# EUROPÄISCHE PATENTSCHRIFT

(11) **EP 2 080 238 B1**
(45) Veröffentlichungstag und Bekanntmachung des Hinweises auf die Patenterteilung: **11.07.2012**
(21) Anmeldenummer: 07820167.0
(22) Anmeldetag: 13.09.2007
(51) Int. Cl.: H01L 41/053, H01L 41/083

(54) **AKTORMODUL MIT EINEM UMHÜLLTEN PIEZOAKTOR**
ACTUATOR MODULE COMPRISING AN ENVELOPED PIEZOACTUATOR
MODULE ACTIONNEUR DOTÉ D'UN ACTIONNEUR PIÉZO-ÉLECTRIQUE ENVELOPPÉ

(30) Priorität: 09.10.2006 DE 102006047606
(43) Veröffentlichungstag der Anmeldung: 22.07.2009
(73) Patentinhaber: Robert Bosch GmbH, 70442 Stuttgart (DE)
(72) Erfinder: HEINZ, Rudolf, 71272 Renningen (DE); KIENZLER, Dieter, 71229 Leonberg (DE); SCHAICH, Udo, 70378 Stuttgart (DE)
(86) Internationale Anmeldenummer: PCT/EP2007/059613
(87) Internationale Veröffentlichungsnummer: WO 2008/043636

(56) Entgegenhaltungen:
- WO-A-2004/006348
- DE-A1- 10 048 430
- DE-A1- 10 054 017
- DE-A1- 10 257 445
- DE-A1- 19 914 411
- JP-A- 2 125 674

## Beschreibung

### Stand der Technik

Die Erfindung betrifft ein Aktormodul mit einem eine Umhüllung aufweisenden Piezoaktor, gemäß der Gattung des Hauptanspruchs der beispielsweise in einem Piezoinjektor zur zeitpunkt- und mengengenauen Dosierung von Kraftstoff in einem Verbrennungsmotor eingesetzt werden kann.

Ein solcher Piezoinjektor besteht im Wesentlichen aus einem Haltekörper und dem im Haltekörper angeordneten Piezoaktor, der zwischen einem Aktorkopf und einem Aktorfuß angeordnete, übereinandergestapelte Piezoelemente aufweist, die jeweils aus mit Innenelektroden eingefassten Piezolagen bestehen. Die Piezoelemente sind unter Verwendung eines Materials mit einer geeigneten Kristallstruktur (Piezokeramik) für die Piezolagen so aufgebaut, dass bei Anlage einer äußeren Spannung an die Innenelektroden eine mechanische Reaktion der Piezoelemente erfolgt, die in Abhängigkeit von der Kristallstruktur und der Anlagebereiche der elektrischen Spannung einen Druck oder Zug in eine vorgebbare Richtung darstellt. Der Piezoaktor ist bei einem Piezoinjektor mit einer Düsennadel verbunden, sodass durch Anlegen einer Spannung an die Piezoelemente eine Düsenöffnung freigegeben wird.

In Diesel-Piezoinjektoren werden bei der so genannten direkten Düsennadelsteuerung die Piezoaktoren direkt im Dieselkraftstoff unter Hochdruck betrieben. Zum Schutz der Piezoelemente, beispielsweise im Hinblick auf deren elektrische Isolation, ist es bekannt, den Piezoaktor mit einem dieselfesten Elastomer zu umhüllen. Nachteilig hieran ist, dass hierfür verwendete Elastomere nicht diffusionsfest gegenüber Dieselkraftstoff, Wasser sowie sonstigen Medien im Kraftstoff sind.

Aus DE 10139 871 A1 ist ein Piezoinjektor mit einem über einen hydraulischen Druckübersetzer auf ein Ventilglied einwirkenden Aktormodul bekannt, bei dem die Piezoelemente des Piezoaktors in einer mit einem Wellbalg versehenen Hülse angeordnet sind.

In der Schrift DE 102 57 445 A1 ist piezoelektrischer Aktuator mit einem piezoelektrischen Element offenbart. Dieser ist von einer Metalleinfassung mit einer Balgstruktur umgeben, damit ein Ausdehnen und Zusammenziehen des piezoelektrischen Elements nicht behindert wird.

### Offenbarung der Erfindung

Die Erfindung geht von einem eingangs beschriebenen Aktormodul mit einem Piezoaktor aus, der zwischen einem Aktorkopf und einem Aktorfuß angeordnete Piezoelemente und eine mindestens die Piezoelemente umgebende flüssigkeitsdichte Umhüllung des Piezoaktors aufweist. Erfindungemäß weist eine über einer Elastomerschicht liegende Umhüllung in vorteilhafter Weise zumindest in Teilbereichen durch Wellen gebildete Rillen und Teleskoprohre auf, mit denen durch ihre Ausrichtung auf dem Umfang der Umhüllung radiale und/oder axiale Dehnbewegungen des Piezoaktors und/oder der Elastomerschicht aufgefangen werden können.

Zusätzlich zu der notwendigen diffusionsdichten Umhüllung des Piezoaktors ist die erfindungsgemäße Weiterbildung des Aktormoduls insbesondere dadurch vorteilhaft, dass die unter der Umhüllung befindliche Elastomerschicht sich bei einer Erwärmung ungehindert ausdehnen kann, ohne die Umhüllung durch den entstehenden Innendruck mechanisch, beispielsweise durch Risse, zu zerstören. Weiterhin können mit der Erfindung Luftblasen und Hohlräume in der Elastomerschicht verdichtet werden, ohne dass die Umhüllung reißt.

In einem Beispiel, welches nicht Bestand teil der Erfindung ist, ist das Aktormodul mit einem Wellbalg als Umhüllung versehen, wobei der Wellbalg an seinem Umfang die in Teilbereichen durch Wellen gebildete Rillen aufweist, mit denen durch ihre Ausrichtung auf dem Umfang der Umhüllung radiale und/oder axiale Dehnbewegungen des Piezoaktors und/oder der Elastomerschicht auffangbar sind.

Gemäß einer Ausführungsform des erfindungsgemäßen Aktormoduls ist die Umhüllung aus ineinander geführten Teleskoprohren gebildet, von denen vorzugsweise mindestens eines die an ihrem Umfang in Teilbereichen durch Wellen gebildete Rillen aufweist, mit denen durch ihre Ausrichtung auf dem Umfang der Umhüllung radiale und/oder axiale Dehnbewegungen des Piezoaktors und/oder der Elastomerschicht auffangbar sind.

Bei dieser Ausführungsform können auch die Zwischenräume zwischen den ineinandergefügten Teleskoprohren mit Elastomer ausgefüllt sein, wodurch in vorteilhafter Weise die Diffusionsstrecke der umgebenden Flüssigkeit verlängert und die Diffusionsfläche im Vergleich zur auf dem Piezoaktor aufliegenden Elastomerschicht verkleinert wird.

Wenn hier glatte Teleskoprohre als Umhüllungen verwendet werden, so findet ein axialer Dehnungsausgleich zwischen den mit Elastomer gefüllten Teleskoprohren statt, wobei durch den relativ schmalen Spalt zwischen den Teleskoprohren das Elastomer stark geschert wird aber ein radialer Dehnungsausgleich, zum Beispiel bei einer Wärmedehnung, kaum möglich ist. Mit der erfindungsgemäß vorteilhaften Anordnung von Rillen ist daher sowohl ein radialer als auch ein axialer Dehnungsausgleich wesentlich erleichtert.

Die vorgeschlagenen Rillen können dabei vorzugsweise sich axial erstreckende Längsrillen sein, die dann eine axiale Wärmedehnung des Piezoaktors erleichtern, ohne dass eine Gefahr der Beschädigung der Umhüllung besteht. Andererseits können die vorgeschlagenen Rillen auch sich radial erstreckende Querrillen sein, die eine radiale Dehnung des Piezoaktors auffangen, wodurch die Schubspannungen im Elastomer verringert werden. Die Rillen können jedoch auch als ein- oder mehrgängige sowie rechts-und/oder linksgängige in einem vorgegebenen Winkel zur Längs- oder Querachse des Piezoaktors verlaufende Rillen ausgebildet sein oder es kann auch eine Kombination von allen vorgeschlagenen Ausbildungen der Rillen angeordnet werden.

Insbesondere durch die axiale Komponente der Ausrichtung der Rillen kann somit auf einfache Weise sichergestellt werden, dass der Innendruck der Elastomerschicht bei einer Wärmedehnung sich abbauen kann und das Aktormodul oder die Umhüllung nicht schädigt. Bei den restlichen Luftblasen oder sonstigen verbleibenden Hohlräumen zwischen der Elastomerschicht und der Umhüllung können die Längsrillen radial leicht nachgeben und die Luft komprimieren, ebenfalls ohne die restliche Umhüllung zu beschädigen.

Die gewindeförmigen oder wendelförmigen Rillen können insbesondere zur Erleichterung der Fertigung vorgesehen werden, da diese mit einem Rollwerkzeug einfach herstellbar sind. Um Torsionsbewegungen auszuschließen, kann dabei in vorteilhafter Weise sowohl ein rechts- und ein linksgängiger wendelförmiger Rillenbereich angeordnet werden.

Die Rillen oder verschiedene Kombinationen der Rillen können dabei beispielsweise im Mittelbereich der Umhüllung oder in Bereichen mindestens an einem seitlichen Ende in der Längserstreckung oder auch auf der ganzen Umhüllung angeordnet werden. Die Anordnungen von Längsrillen oder wendelförmigen oder orthogonalen Querrillen können dabei je nach Bedarf der aufzufangenden Längs- oder Querdehnung auf dem Umfang in der Längserstreckung des Wellbalges, einer teleskopartigen oder sonstigen Umhüllung verteilt werden, wobei auch die Längen bzw. die Winkel bei der wendelförmigen Umfangsrille, beispielsweise in einem Bereich von 0° bis 45°, variiert und kombiniert werden können.

Die Umhüllung als Wellbalg oder als Teleskop des erfindungemäßen Aktormoduls kann bevorzugt aus einem metallischen Material wie Stahl hergestellt sein. Der Wellbalg oder die Teleskoprohre können dabei auf einfache Weise mit dem Aktorkopf und/oder dem Aktorfuß, in der Regel auch aus Stahl, des Piezoaktors verschweißt werden.

Eine bevorzugte Anwendung des erfindungemäßen Aktormoduls ergibt sich, wenn, wie schon in der Beschreibungseinleitung erwähnt, der Piezoaktor Bestandteil eines Piezoinjektors für ein Einspritzsystem für Kraftstoff bei einem Verbrennungsmotor ist, wobei der Kraftstoff die Umhüllung umströmt.

### Kurze Beschreibung der Zeichnungen

Die Erfindung wird nachfolgend anhand der Zeichnungen erläutert. Dabei zeigen:
- Figur 1: eine schematische Darstellung eines Piezoinjektors mit einem Aktormodul nach dem Stand der Technik im Längsschnitt,
- Figur 2: eine schematische Darstellung eines bekannten Aktormoduls mit einem Wellbalg ,
- Figur 3: eine Darstellung eines Aktormoduls als Längsschnitt durch die Figur 2 mit einem Wellbalg mit Längsrillen in einer mittigen radial elastischen Zone,
- Figur 4: einen Querschnitt durch das Aktormodul nach der Figur 3 an der Schnittlinie A-A,
- Figur 5: eine Darstellung eines Wellbalgs mit Längsrillen in den Seitenbereichen und
- Figur 6: eine Darstellung eines Wellbalgs mit wendelförmigen Querrillen,
- Figur 7: eine schematische Darstellung eines erfindungsgemäßen Aktormoduls mit Teleskoprohren als Ausführungsbeispiel einer Umhüllung des Piezoaktors,
- Figur 8: eine Darstellung eines Aktormoduls mit Querrillen nach Art eines Wellbalgs in einer seitlichen axial elastischen Zone eines Teleskoprohres,
- Figur 9: eine Darstellung eines Aktormoduls mit Längsrillen in einer seitlichen radial elastischen Zone eines hier äußeren Teleskoprohres,
- Figur 10: einen Schnitt durch das Aktormodul nach der Figur 9 an der Schnittlinie A-A und
- Figur 11: eine Darstellung eines Aktormoduls mit Längsrillen sowohl auf dem inneren als auch auf dem äußeren Teleskoprohr in nahezu der ganzen Länge.

### Ausführungsformen der Erfindung

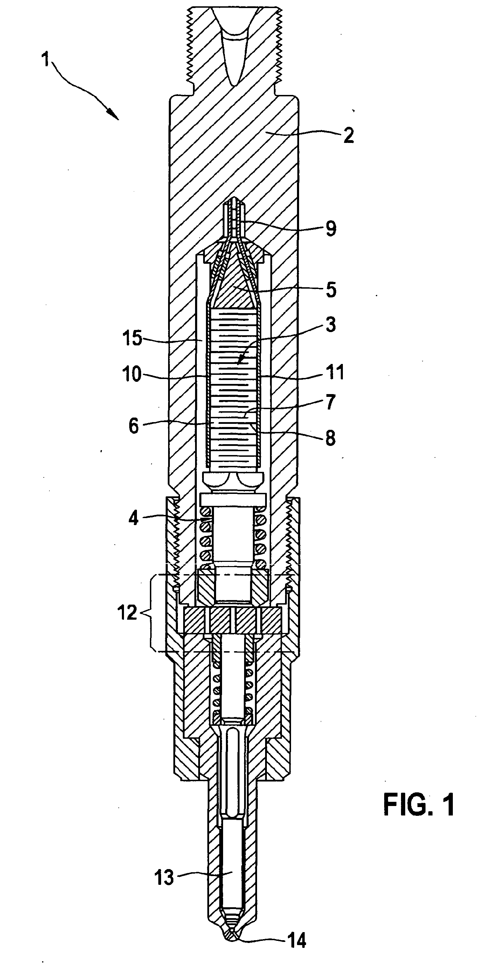

Ein in Figur 1 zur Erläuterung des erfindungemäßen Aktormoduls dargestellter Piezoinjektor 1 nach dem Stand der Technik umfasst im Wesentlichen einen Haltekörper 2 und einen in dem Haltekörper 2 angeordneten Piezoaktor 3, der ein Aktorkopf 4 und einen Aktorfuß 5 aufweist. Es sind dabei zwischen dem Aktorkopf 4 und dem Aktorfuß 5 mehrere übereinandergestapelte Piezoelemente 6 vorhanden, die jeweils aus Piezolagen aus Piezokeramik und diese einschließende Innenelektroden 7 und 8 bestehen.

Die Innenelektroden 7 und 8 der Piezoelemente 6 sind über ein Steckerteil 9 mit Zuleitungen zu Außenelektroden 10 und 11 elektrisch kontaktiert. Der Piezoaktor 3, der mit weiteren, hier nicht näher gezeigten Bauteilen ein sogenanntes Aktormodul darstellt, ist über einen Koppler 12 mit einer Düsennadel 13 verbunden. Durch Anlegen einer Spannung an die Piezoelemente 6 über die Innenelektroden 7 und 8 und die daraus folgende mechanische Reaktion wird, wie in der Beschreibungseinleitung erläutert, eine Düsenöffnung 14 freigegeben. Das Aktormodul mit dem Piezoaktor 3 wird bei der dargestellten Anwendung nach der Figur 1 als Piezoinjektor in einem Raum 15 von dem zu dosierenden Kraftstoff umströmt.

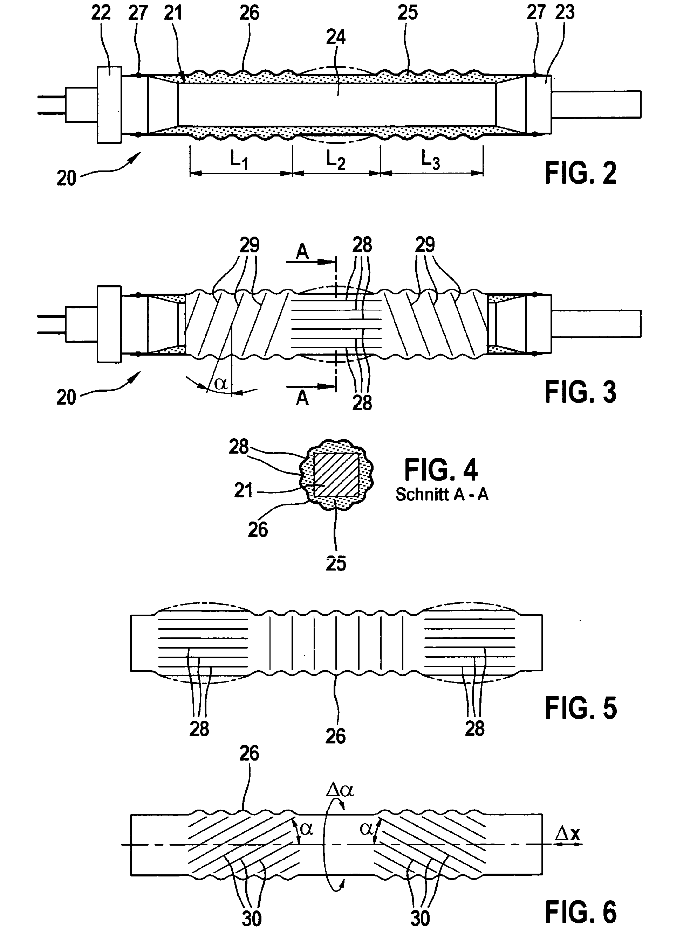

In Figur 2 ist ein beispielhaftes Aktormodul 20 mit einem Piezoaktor 21 dargestellt, der hier vom Aktorkopf 22 zum Aktorfuß 23 einschließlich der Piezoelemente 24 mit einer elektrisch isolierenden Elastomerschicht 25 umgeben ist. Um die Elastomerschicht 25 herum befindet sich ein metallischer Wellbalg 26 als flüssigkeitsdichte Umhüllung. Der Wellbalg 26 ist an seinen beiden Enden mit jeweils einer Schweißverbindung 27 mit dem Aktorkopf 22 und dem Aktorfuß 23 verbunden. Der Wellbalg 26 dient dabei sowohl einer diffusionsdichten Abdichtung der Piezoelemente 24 gegenüber einem umgebenden Kraftstoff eines Piezoinjektors, als auch einem elastischen Auffangen von thermischen und mechanischen Längsdehnungen des Piezoaktors 21 ohne große Längskrafterzeugung und dem Auffangen von thermischen oder sonst wie bedingten Volumenänderungen der Elastomerschicht 25.

Da bei einem Einsatz in einem Piezoinjektor von allen Seiten der relativ hohe Kraftstoffdruck am Wellbalg 26 absteht und der Wellbalg 26 aus Platzgründen relativ dünn ist, muss die Elastomerschicht 25 den Innenraum zwischen dem Piezoaktor 21 und dem *Wellbalg 26 vollständig ausfüllen. Dadurch kommt der Wellbalg 26 ohne zusätzliche Zug-oder Druckspannungen unter allseitigem Druck. In der Figur 2 sind Bereiche L₁ und L₃ des Wellbalgs 26 zu erkennen und es ist ein mittiger Bereich L₂ vorhanden, der hier radiale Dehnungen auffangen soll.

Um eine radiale Wärmedehnung der Elastomerschicht 25 wesentlich zu erleichtern, ohne eine radiale Zugspannung in dem Wellbalg 26 zu erzeugen, sind beim Beispiel nach Figur 3 Längsrillen 28 in einem mittigen Bereich angeordnet. In den seitlichen Bereichen des Wellenbalgs 26 sind, anstatt der radialen Umfangsrillen des Wellbalges 26 nach der Figur 2, in der Figur 3 gewindeförmige oder wendelförmige Umfangsrillen 29 mit einem Steigungswinkel zur radialen Umfangsrille vorgesehen. Um Torsionsbewegungen zu erleichtern, ohne die Piezoelemente 24 zu belasten, sind hier auf beiden Seiten der Längsrillen 28 unterschiedliche rechts- oder linksgängige wendelförmige Umfangsrillen 29 angeordnet.

Figur 4 zeigt einen Schnitt durch das Aktormodul 20 nach der Figur 3 an der Schnittlinie A-A, wobei hier die Längsrillen 28 im Wellbalg 26 sowie die den Piezoaktor 21 umgebende Elastomerschicht 25 erkennbar ist.

Aus Figur 5 ist ein Beispiel zu entnehmen, bei der die Längsrillen 28 beiderseits eines mittigen Bereiches des Wellbalgs 26 angeordnet sind.

Figur 6 zeigt auf beiden seitlichen Bereichen des Wellenbalgs 26 angeordnete unterschiedlich rechts- oder linksgängige wendelförmige Umfangsrillen 30, die hier einen Steigungswinkel zur Längsachse des Piezoaktors aufweisen. In der Figur 6 ist noch der auftretende Hub x des Piezoaktors eingezeichnet, der zu einer Torsion zwischen den seitlichen Bereichen mit den unterschiedlich rechts oder linksgängigen wendelförmigen Umfangsrillen 30 führt. Durch eine Optimierung des Steigungswinkels und der Anzahl der Umfangsrillen 30 kann die Torsion minimiert werden, sodass die Steifigkeit in der x-Richtung (Hubrichtung des Piezoaktors) klein bleibt.

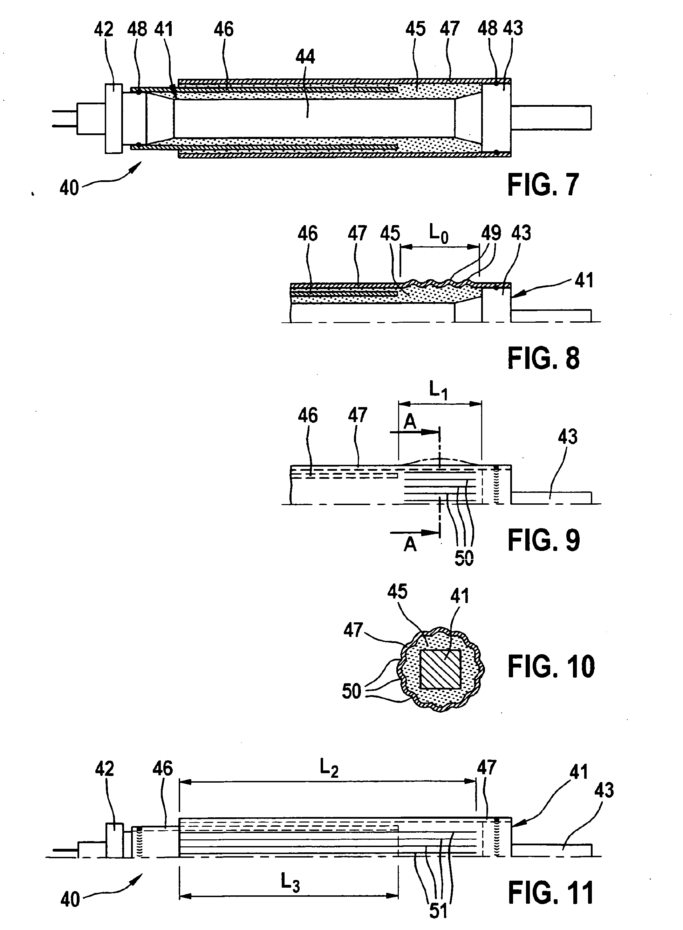

Ein Ausführungsbeispiel der Erfindung ist in Figur 7 mit einem Aktormodul 40 mit einem Piezoaktor 41 dargestelft, der hier vom Aktorkopf 42 zum Aktorfuß 43 einschließlich der Piezoelemente 44 ebenfalls mit einer elektrisch isolierenden Elastomerschicht 45 umgeben ist. Um die Elastomerschicht 45 herum befindet sich hier ein inneres Teleskoprohr 46 und ein äußeres Teleskoprohr 47 als flüssigkeitsdichte Umhüllung. Das innere Teleskoprohr 46 ist am Aktorkopf 42 und das äußere Teleskoprohr 47 ist am Aktorfuß 43 jeweils mittels einer Schweißverbindung 48 angeschweißt.

Bei dem Ausführungsbeispiel nach der Figur 7 können auch die Zwischenräume zwischen den Teleskoprohren 46 und 47 mit dem erwähnten Elastomer der Elastomerschicht 45 ausgefüllt sein, wobei durch den relativ schmalen Spalt bei mechanischer Längsdehnung diese Elastomerbereiche stark geschert werden. Ein radialer Dehnungsausgleich, zum Beispiel bei einer Wärmedehnung der Elastomerschicht 45 ist kaum möglich ist sondern nur eine Schubdehnung zwischen den beiden Teleskoprohren 46 und 47.

In Figur 8 ist eine Ausführungsform zur Verbesserung der Anordnung nach der Figur 7 gezeigt, bei der zur Vermeidung der hohen axialen Dehnung der Elastomerschicht 45 zwischen den beiden Teleskoprohren 46 und 47 ein Bereich L₀ mit Querrillen 49 umlaufend auf dem Umfang des äußeren Teleskoprohres 47 angeordnet ist. Die Länge des Bereichs L₀ ist dabei jeweils an die erforderlichen Verhältnisse zum Dehnungsausgleich anpassbar.

Bei einer Ausführungsform nach Figur 9 sind in einem Bereich L₁ auf dem äußeren Teleskoprohr 47 Längsrillen 50 in einem seitlichen Bereich angebracht, die insbesondere die radiale Wärmedehnung der Elastomerschicht 45 besonders gut ausgleichen können. Aus Figur 10 ist ein Schnitt durch das Aktormodul nach der Figur 9 an der Schnittlinie A-A im Bereich des äußeren Teleskoprohres 47 mit den Längsrillen 50 zu entnehmen.

Figur 11 zeigt eine Darstellung des Aktormoduls 40 mit dem Piezoaktor 41 mit Längsrillen 51 auf dem äußeren Teleskoprohr 47 in der gesamten Längsausdehnung L₂, wobei auch entsprechende Längsrillen auf dem inneren Teleskoprohr 46 in der gleichen Weise mit einer Länge L₃ angebracht werden können. Es ist außerdem, in hier nicht dargestellter Weise, eine Kombination der Querrillen 49 nach der Figur 8 und der Längsrillen 51 nach der Figur 11 möglich.

## Patentansprüche

1. Aktormodul mit einem Piezoaktor (3), der zwischen einem Aktorkopf (4) und einem Aktorfuß (5) angeordnete Piezoelemente (6) aufweist, mit einer mindestens die Piezoelemente (6) umschließenden Elastomerschicht und mit einer flüssigkeitsdichten Umhüllung des Piezoaktors (3), **dadurch gekennzeichnet, dass** die Umhüllung aus ineinander geführten Teleskoprohren (46,47) gebildet ist, von den mindestens eines die an ihrem Umfang die in Teilbereichen durch Wellen gebildete Rillen (49;50;51) aufweist, mit denen durch ihre Ausrichtung auf dem Umfang der Umhüllung radiale und/oder axiale Dehnbewegungen des Piezoaktors (45) und/oder der Elastomerschicht (45) auffangbar sind.

2. Aktormodul nach Anspruch 1, **dadurch gekennzeichnet, dass** die Rillen sich axial erstreckende Längsrillen (28;50;51) sind.

3. Aktormodul nach Anspruch 1 oder in Kombination mit Anspruch 2, **dadurch gekennzeichnet, dass** die Rillen sich radial erstreckende Querrillen (49) sind.

4. Aktormodul nach Anspruch 1 oder in Kombination mit Anspruch 2 oder 3 **dadurch gekennzeichnet, dass** die Rillen als ein- oder mehrgängige sowie rechts- und/oder linksgängige in einem vorgegebenen Winkel ( ) zur Längs- oder Querachse des Piezoaktors (21) verlaufende Rillen (29;30) ausgebildet sind.

5. Aktormodul nach einem der vorhergehenden Ansprüche, **dadurch gekennzeichnet, dass** die Rillen im Mittelbereich der Umhüllung (26;46,47) angeordnet sind.

6. Aktormodul nach einem der vorhergehenden Ansprüche, **dadurch gekennzeichnet, dass** die Rillen in Bereichen mindestens an einem seitlichen Ende in der Längserstreckung der Umhüllung (26;46,47) gebildet sind.

7. Aktormodul nach einem der vorhergehenden Ansprüche, **dadurch gekennzeichnet, dass** die Umhüllung (26;46,47) aus einem Metall, insbesondere aus dünnwandigem Stahl hergestellt ist.

8. Aktormodul nach einem der vorhergehenden Ansprüche, **dadurch gekennzeichnet, dass** die Umhüllung (26;46,47) mit dem metallischen Aktorkopf (22;42) und/oder dem metallischen Aktorfuß (23;43) des Piezoaktors (21;41) verschweißt (27) ist.

9. Aktormodul nach einem der vorhergehenden Ansprüche, **dadurch gekennzeichnet, dass** der Piezoaktor (21;41) Bestandteil eines Piezoinjektors (1) für ein Einspritzsystem für Kraftstoff bei einem Verbrennungsmotor ist, wobei der Kraftstoff die Umhüllung (26;46,47) umströmt.

## Claims

1. Actuator module comprising a piezo actuator (3), which has piezo elements (6) arranged between an actuator head (4) and an actuator foot (5), comprising an elastomer layer, enclosing at least the piezo elements (6), and comprising a liquid-impermeable envelope of the piezo actuator (3), **characterized in that** the envelope is formed by telescopic tubes (46, 47) guided one inside the other, at least one of which has on its circumference grooves (49; 50; 51) which are formed in sub-regions by undulations and, by their alignment on the circumference of the envelope, allow radial and/or axial expansion movements of the piezo actuator (21) and/or the elastomer layer (45) to be absorbed.

2. Actuator module according to Claim 1, **characterized in that** the grooves are axially extending longitudinal grooves (28; 50; 51).

3. Actuator module according to Claim 1 or in combination with Claim 2, **characterized in that** the grooves are radially extending transverse grooves (49).

4. Actuator module according to Claim 1 or in combination with Claim 2 or 3, **characterized in that** the grooves are formed as single- or multi-thread and clockwise and/or anticlockwise grooves (29; 30) extending at a predetermined angle (α) to the longitudinal or transverse axis of the piezo actuator (21).

5. Actuator module according to one of the preceding claims, **characterized in that** the grooves are arranged in the middle region of the envelope (26; 46, 47).

6. Actuator module according to one of the preceding claims, **characterized in that** the grooves are formed in regions at least at one lateral end in the longitudinal extent of the envelope (26; 46, 47).

7. Actuator module according to one of the preceding claims, **characterized in that** the envelope (26; 46, 47) is produced from a metal, in particular from thin-walled steel.

8. Actuator module according to one of the preceding claims, **characterized in that** the envelope (26; 46, 47) is welded (27) to the metal actuator head (22; 42) and/or the metal actuator foot (23; 43) of the piezo actuator (21; 41).

9. Actuator module according to one of the preceding claims, **characterized in that** the piezo actuator (21; 41) is a component part of a piezo injector (1) for an injection system for fuel in an internal combustion engine, the fuel flowing around the envelope (26; 46, 47).

## Revendications

1. Module d'actionneur doté d'un piézoactionneur (3) qui présente des piézoéléments (6) disposés entre une tête d'actionneur (4) et un pied d'actionneur (5),
une couche d'élastomère entourant au moins les piézoéléments (6) et le piézoactionneur (4) étant enveloppé de manière étanche aux liquides,
**caractérisé en ce que**
l'enveloppe est formée de tubes télescopiques (46, 47) insérés l'un dans l'autre, dont au moins l'un présente à sa périphérie des rainures (49; 50; 51) formées dans des parties par des ondulations et dont l'orientation à la périphérie de l'enveloppe permet de reprendre des déplacements de dilatation radiale et/ou axiale du piézoactionneur (21) et/ou de la couche élastomère (45).

2. Module d'actionneur selon la revendication 1, **caractérisé en ce que** les rainures sont des rainures longitudinales (28; 50; 51) qui s'étendent axialement.

3. Module d'actionneur selon la revendication 1 ou en combinaison avec la revendication 2, **caractérisé en ce que** les rainures sont des rainures transversales (49) qui s'étendent radialement.

4. Module d'actionneur selon la revendication 1 ou en combinaison avec les revendications 2 ou 3, **caractérisé en ce que** les rainures sont configurées comme rainures (29; 30) à un ou plusieurs pas et à pas droit et/ou à pas gauche à un angle prédéterminé (α) par rapport à l'axe longitudinal ou l'axe transversal du piézoactionneur (21).

5. Module d'actionneur selon l'une des revendications précédentes, **caractérisé en ce que** les rainures sont disposées dans la partie centrale de l'enveloppe (26; 46, 47).

6. Module d'actionneur selon l'une des revendications précédentes, **caractérisé en ce que** les rainures sont formées dans des parties situées au moins à une extrémité latérale de l'extension longitudinale de l'enveloppe (26; 46, 47).

7. Module d'actionneur selon l'une des revendications précédentes, **caractérisé en ce que** l'enveloppe (26; 46, 47) est réalisée en un métal et en particulier en acier à paroi mince.

8. Module d'actionneur selon l'une des revendications précédentes, **caractérisé en ce que** l'enveloppe (26; 46, 47) est soudée (27) à la tête métallique d'actionneur (22; 42) et/ou au pied métallique d'actionneur (23; 43) du piézoactionneur (21; 41).

9. Module d'actionneur selon l'une des revendications précédentes, **caractérisé en ce que** le piézoactionneur (21; 41) fait partie d'un piézoinjecteur (1) pour système d'injection de carburant de moteur à combustion interne, le carburant balayant l'enveloppe (26; 46, 47).
